# EUROPEAN PATENT APPLICATION

(11) **EP 3 792 620 A1**
(43) Date of publication of application: **17.03.2021**
(21) Application number: 20194340.4
(22) Date of filing: 03.09.2020
(51) Int. Cl.: G01N 21/91, G01N 27/84, G06K 9/66, G01N 21/89, G01N 21/88

(54) **MAGNETIC PARTICLE INSPECTION DEVICE**

(30) Priority: 12.09.2019 JP 2019166088
(71) Applicant: JTEKT CORPORATION, Chuo-ku, Osaka-shi, Osaka 542-8502 (JP)
(72) Inventor: ARAI, Yuki, Osaka-shi, Osaka 542-8502 (JP)
(74) Representative: Winter, Brandl, Fürniss, Hübner, Röss, Kaiser, Polte - Partnerschaft mbB

(57) **Abstract**

A magnetic particle inspection device includes an image acquisition unit (110) configured to acquire an image obtained by attaching magnetic particles (201) to a magnetized inspection object (200) and capturing the image of the inspection object (200), and a binarized image obtained by binarizing a whole or a part of the image; a region specifying unit (120) configured to specify a magnetic particle group region (203) based on at least one of the image and the binarized image, the magnetic particle group region (203) containing a magnetic particle group (202); and a detection unit (130) configured to detect a flaw by processing luminance information and form information with artificial intelligence obtained by supervised learning, the luminance information being obtained by performing statistical processing on luminances of a plurality of minute regions in the specified magnetic particle group region (203), and the form information being information regarding a form of the magnetic particle group (202) that is obtained from the binarized image.

## Description

### BACKGROUND OF THE INVENTION

### 1. Field of the Invention

The invention relates to a magnetic particle inspection device that determines whether there is a flaw on an inspection object including an edge.

### 2. Description of Related Art

A magnetic particle inspection is performed for detecting a flaw such as a crack that exists on a surface of an inspection object made of a ferromagnetic material such as an iron material or a steel material. In a magnetic particle inspection test, magnetic particles are attached to the inspection object such that the flaw becomes conspicuous, and the flaw is detected by visual observation or the like.

For example, Japanese Patent Application Publication No. 2017-173251 (JP 2017-173251 A) discloses a technology of determining whether there is a flaw, by photographing a test object to which magnetic particles have been attached, with a camera, and analyzing the obtained image.

### SUMMARY OF THE INVENTION

However, in the magnetic particle inspection based on the image analysis described in JP 2017-173251 A, in the case where the inspection object is, for example, a rack shaft including continuous teeth (i.e., including a rack), there are many edges of the teeth on an inspection portion. Therefore, it is difficult to discriminate between the flaw and the edge and detect only the flaw. It is conceivable to recognize the positions of the edges of the inspection object and to remove the edge portions. However, it is difficult to detect a flaw that is formed so as to overlap with the edge.

Further, the magnitude of leakage magnetic flux at the flaw is close to that at the edge, and the state of attached magnetic particles at the flaw is similar to that at the edge. Therefore, it is difficult to check whether there is a flaw, even by visual observation.

The invention extracts a particular feature quantity "that is advantageous for the discrimination between the flaw and the edge", from a magnetic particle group containing flaw candidates, and determines whether the magnetic particle group is a magnetic particle group attached to the edge or a magnetic particle group attached to the flaw, using an artificial intelligence.

A magnetic particle inspection device according to an aspect of the invention includes an image acquisition unit configured to acquire an image that is obtained by attaching magnetic particles to an inspection object that is magnetized and capturing the image of the inspection object, and a binarized image that is obtained by binarizing a whole or a part of the image; a region specifying unit configured to specify a magnetic particle group region based on at least one of the image and the binarized image, the magnetic particle group region containing a magnetic particle group that is a mass of the magnetic particles; and a detection unit configured to detect a flaw by processing luminance information and form information with artificial intelligence that is obtained by supervised learning, the luminance information being obtained by performing statistical processing on luminances of a plurality of minute regions in the specified magnetic particle group region, and the form information being information regarding a form of the magnetic particle group that is obtained from the binarized image.

With the above aspect of the invention, it is possible to improve detection accuracy for the flaw of the inspection object, even when the edge of the inspection object is included in the image.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is an image showing a surface of a part of an inspection object to which luminescent magnetic particles have been attached;
FIG. 2 is a block diagram showing the functional configuration of a magnetic particle inspection device;
FIG. 3 is a conceptual diagram showing a magnetic particle group region specified by a region specifying unit; and
FIG. 4 is a block diagram showing the functional configuration of an inspection model learning device.

### DETAILED DESCRIPTION OF EMBODIMENTS

A magnetic particle inspection device according to an embodiment of the invention will be described below with reference to the drawings. Numerical values, forms, materials, constituent elements, positional relations of constituent elements, connection states, steps, orders of steps, and the like that are shown in the following embodiment are examples, and do not limit the invention. A constituent element that is not described in a claim is regarded as an arbitrary constituent element for the invention according to the claim. Further, the drawings are schematic drawings in which emphasis, omission and proportion adjustment are appropriately performed for description of the invention, and forms, positional relations and proportions in the drawings are sometimes different from actual forms, positional relations and proportions.

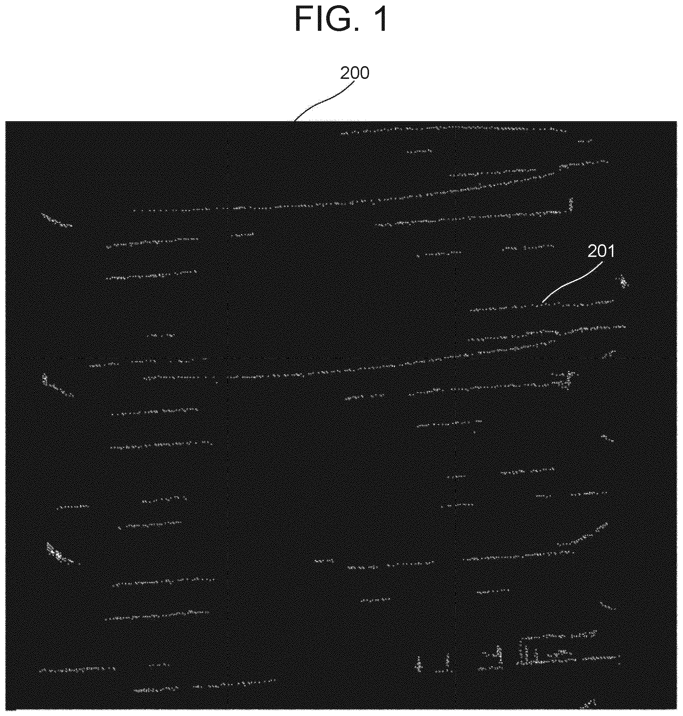

FIG. 1 is an image showing a surface of a part of an inspection object to which luminescent magnetic particles have been attached. The image shown in FIG. 1 is an image after binarization processing (i.e., an image that has been subjected to binarization processing). The image includes an inspection object 200, and magnetic particles 201 that are attached to edges, flaw and so on of the inspection object 200 and that are in a luminous state (i.e., a light-emitting state).

The inspection object 200 is not particularly limited, as long as the inspection object 200 is made of a ferromagnetic material that can be magnetized and that allows the magnetic particles 201 to be attached to a surface of the inspection object 200 after the magnetization (i.e., a surface of the magnetized inspection object 200). In the embodiment, a rack shaft that is made of a steel material and that is used in a steering device of a vehicle is exemplified as the inspection object 200. The rack shaft includes a plurality of teeth on a part of an elongated rod-shaped member (i.e., the rack shaft includes a rack). The plurality of teeth is arranged in a longitudinal direction. Each tooth extends along a direction substantially intersecting the longitudinal direction.

There are various possible causes for the flaw generated on the surface of the inspection object 200. For example, a crack generated by heat treatment such as quenching may become the flaw generated on the surface of the inspection object 200. Further, a crack may be generated when the inspection object 200 deformed by heat treatment is restored to the original form.

The magnetic particle 201 is a fine particle that can be attached to the magnetized inspection object 200. Further, it is preferable that the magnetic particle 201 should have a high distinguishability from the surface of the inspection object 200 on a captured image. In the embodiment, the magnetic particle 201 is a so-called fluorescent magnetic particle that has a fluorescent substance attached to a surface thereof. The captured image of the magnetic particle 201 has a higher luminance than that of the surface of the inspection object 200 because of the light emission of the magnetic particle 201. The luminescent color of the magnetic particle 201 is not particularly limited. As long as the luminescent color makes it possible to capture the image of the magnetic particle 201, infrared light, ultraviolet light and the like may be adopted in addition to visible light. Further, the magnetic particle 201 may be a magnetic particle that stores light, or may be a magnetic particle that emits light only during irradiation with exciting light such as black light.

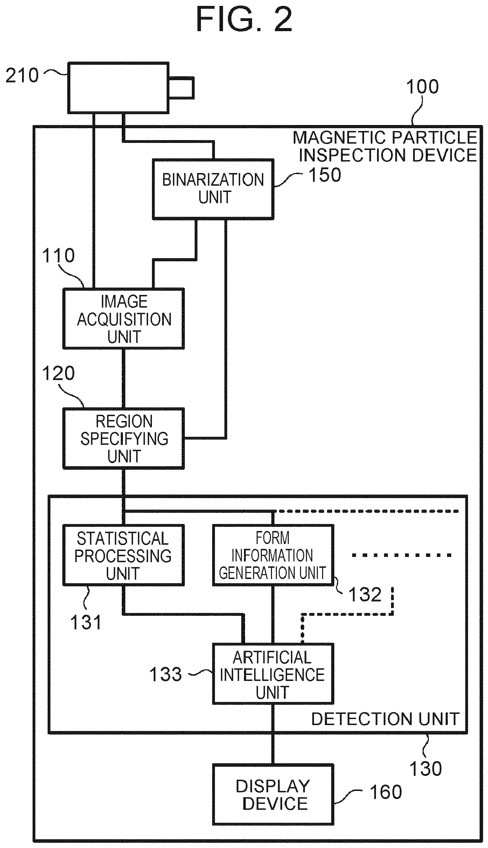

FIG. 2 is a block diagram showing the functional configuration of a magnetic particle inspection device according to the embodiment. As shown in FIG. 2, the magnetic particle inspection device 100 detects a flaw based on the image of the surface of the inspection object 200 to which the magnetic particles 201 have been attached, and includes an image acquisition unit 110, a region specifying unit 120 and a detection unit 130. In other words, the magnetic particle inspection device 100 includes an electronic control unit (ECU) including a processor, and so on. In the embodiment, the magnetic particle inspection device 100 includes a display device 160 and a binarization unit 150.

The image acquisition unit 110 acquires an image that is obtained by attaching the magnetic particles 201 to the magnetized inspection object 200 and capturing the image of the magnetic particles 201 in the luminous state, and a binarized image that is obtained by the binarization of the image by the binarization unit 150. In the embodiment, the image acquisition unit 110 acquires a continuous-tone digital image from an image-capturing device 210 that captures an image of the inspection object 200, and a binarized image based on the digital image.

The image-capturing device 210 is a device including an image sensor such as a charge-coupled device (CCD) image sensor and a complementary metal-oxide semiconductor (CMOS) image sensor, and an optical system, for example, and acquires the image of the magnetic particles 201 in the luminous state on the surface of the inspection object 200, as a two-dimensional digital image. Specifically, the image-capturing device 210 photographs the inspection object 200 at a resolution that allows the discrimination of each of the magnetic particles 201 attached to the inspection object 200. In the image photographed in this way, for example, it is desirable that the size of one pixel be equal to or smaller than the size of the magnetic particle 201. In the embodiment, the size of the magnetic particle 201 is several micrometers.

In the case where the image-capturing device 210 is a low-resolution camera, the image-capturing device 210 may photograph each of a plurality of regions obtained by dividing the image of the inspection object 200 into the plurality of regions. For example, the image-capturing device 210 may photograph the inspection object 200 while moving relative to the inspection object 200. Further, the image-capturing device 210 may be a line sensor, and may capture the image of the inspection object 200 by scanning the inspection object 200.

In the embodiment, the image-capturing device 210 is attached and fixed to a jig that fixes the inspection object 200 such that the image-capturing device 210 can capture the images of the inspection objects 200 of the same sort in the same attitude.

The data format of the image that is acquired by the image-capturing device 210 is not particularly limited. Further, the data of the image may be color data, or may be monochrome (grayscale) data.

In the embodiment, the magnetic particle inspection device 100 includes the binarization unit 150 that binarizes the continuous-tone image obtained from the image-capturing device 210. The method by which the binarization unit 150 changes the image into a two-tone image is not particularly limited. For example, in the case where the image obtained from the image-capturing device 210 is a color image, the binarization unit 150 changes the color image into a grayscale image, and then binarizes the digital image based on a binarization threshold for indicating light and shade. In the embodiment, the binarization unit 150 performs the binarization by setting white for the portions of the magnetic particles 201 from which light is captured, and setting black for the other portions (i.e., the remaining portions).

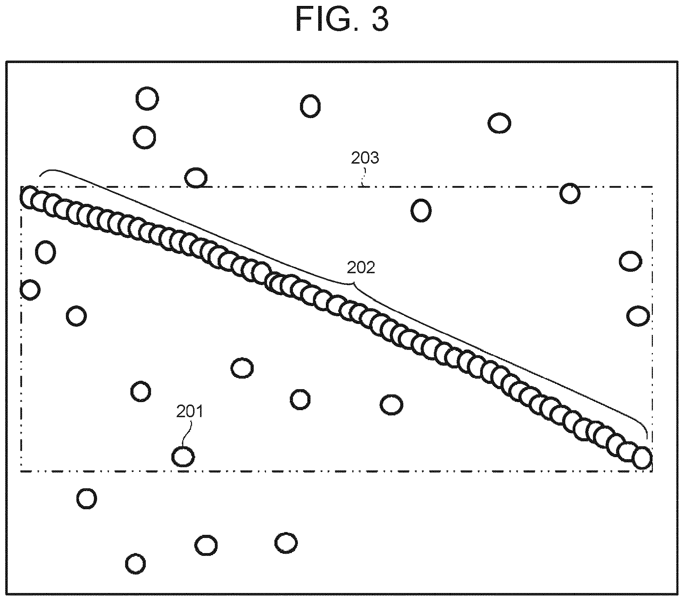

The embodiment is not limited to the case where the binarization unit 150 binarizes the whole of the image. The binarization unit 150 may perform the binarization for the inside of a magnetic particle group region 203 (see FIG. 3) specified from the image by the region specifying unit 120. The binarization unit 150 does not necessarily need to be included in the magnetic particle inspection device 100, and may be included in another device, for example, the image-capturing device 210.

FIG. 3 is a conceptual diagram showing the magnetic particle group region 203 specified by the region specifying unit 120. FIG. 3 does not show the image itself acquired by the image acquisition unit 110, and does not show the image after the binarization by the binarization unit 150. FIG. 3 shows a part of the obtained image. In some cases, a plurality of magnetic particle groups 202 exists in one image.

The region specifying unit 120 performs a process of specifying the magnetic particle group region 203 containing the magnetic particle group 202 that is a mass of magnetic particles 201, based on at least one of the image acquired from the image-capturing device 210 and the binarization image obtained from the binarization unit 150.

The magnetic particle group 202 means a plurality of magnetic particles 201 that spatially continues in the image. The phrase "spatially continues" means that the magnetic particles 201 are positioned such that the distance between adjacent magnetic particles 201 is smaller than a predetermined distance. The predetermined distance is not particularly limited. In the embodiment, the predetermined distance is zero. That is, the magnetic particle group 202 is the mass of the aggregated magnetic particles 201 (i.e., the mass in which adjacent magnetic particles 201 overlap with each other).

Specifically, for example, the region specifying unit 120 analyzes the binarized image, specifies outlines of white portions captured as the magnetic particles 201 or the magnetic particle group 202, and calculates the area of the portions enclosed by the outlines. Then, the region specifying unit 120 specifies a portion for which the calculated area is equal to or larger than an area threshold, as the magnetic particle group 202. The region specifying unit 120 may specify the magnetic particle group 202 using an artificial intelligence model.

The magnetic particle group region 203 is a region that has a predetermined form and that can contain the whole of the magnetic particle group 202 in the image. The form of the magnetic particle group region 203 is not particularly limited. In the embodiment, the region specifying unit 120 adopts a rectangular region as the form of the magnetic particle group region 203. Further, the region specifying unit 120 specifies the magnetic particle group region 203 such that the attitude of the magnetic particle group region 203 in the image is constant. Specifically, for example, the region specifying unit 120 specifies the magnetic particle group region 203 such that a side of the rectangular magnetic particle group region 203 is parallel to a side of the image. Further, the region specifying unit 120 specifies a region with the minimum area that can contain the specified magnetic particle group 202, as the magnetic particle group region 203.

The region specifying unit 120 specifies the magnetic particle group 202 and the magnetic particle group region 203, using at least one of the digital image and the binarized image. When the magnetic particle group region 203 is specified based on one of the images, the magnetic particle group region 203 is associated with the same position in the other of the images. Further, the region specifying unit 120 may perform an operation of removing magnetic particles 201 that do not constitute the magnetic particle group 202, from the magnetic particle group region 203.

The detection unit 130 detects the flaw by processing luminance information and form information with an artificial intelligence model that is obtained by supervised learning. The luminance information is obtained by performing statistical processing on luminances of a plurality of minute regions in the specified magnetic particle group region 203. The form information is information regarding the form of the magnetic particle group 202 that is obtained from the binarized image. In the embodiment, the detection unit 130 includes a statistical processing unit 131, a form information generation unit 132 and an artificial intelligence unit 133. In the detection unit 130, a processing unit that generates a parameter to be input to the artificial intelligence unit 133 may be provided in addition to the statistical processing unit 131 and the form information generation unit 132. A broken line and a dotted line in FIG. 2 suggest the possibility that such a processing unit may be provided.

The statistical processing unit 131 divides the magnetic particle group region 203 specified by the region specifying unit 120, into minute regions, and calculates a parameter to be input to the artificial intelligence unit 133, by performing statistical processing on numerical values obtained from the minute regions. The statistical processing unit 131 calculates at least one of the average of the luminances of the minute regions and the standard deviation of the luminances of the minute regions. In the embodiment, the statistical processing unit 131 sets one pixel of the image as the minute region, and calculates the average of the luminances of the regions and the standard deviation of the luminances of the regions.

The statistical processing unit 131 may calculate parameters to be input to the artificial intelligence unit 133, by performing statistical processing on the chromatic values, brightness values, hue values, and so on of the minute regions, in addition to the luminances.

The form information generation unit 132 calculates the form information regarding the form of the magnetic particle group 202 that is obtained from the two-dimensional binarized image, as a parameter to be input to the artificial intelligence unit 133. In the embodiment, the form information generation unit 132 calculates at least one of a normalized inertia moment and an elongation factor.

The inertial moment is an inertia moment under the assumption that the magnetic particle group 202 in the image is divided into minute regions (for example, one pixel) and each of the minute regions has a certain mass. The inertia moment in the image is a value indicating the distribution of the magnetic particles 201 included in the magnetic particle group 202 with respect to the center of gravity of the magnetic particle group 202. When one side of the magnetic particle group region 203 is set as an x-axis and another side orthogonal to the x-axis is set as a y-axis, there are values Ixx, Iyy, Ixy, Iyx as the inertia moment. In the embodiment, Ixx and Iyy are employed as parameters. Ixx and Iyy are inertia moment coefficients for the x-axis and the y-axis respectively, and Ixy is a product of inertia.

The normalized inertia moment is a value obtained by normalizing the inertia moment with respect to the area of the magnetic particle group region 203.

The elongation factor is a value obtained by dividing the maximum Feret diameter of the magnetic particle group 202 by the length of the short side of an equivalent rectangle shape. The equivalent rectangle shape is a rectangle shape in which the length of the long side is the maximum Feret diameter and the area is the same as the area of the magnetic particle group 202.

The form information generation unit 132 may generate the form information using the form of the magnetic particle group 202 that is used for specifying the magnetic particle group 202 in the region specifying unit 120 and that is obtained by image analysis.

The artificial intelligence unit 133 includes an artificial intelligence model, and inputs the acquired parameters to the artificial intelligence model, and thus determines whether the magnetic particle group 202 is attached to a flaw. The kind of the artificial intelligence model included in the artificial intelligence unit 133 is not particularly limited. For example, a machine learning model may be used. As a specific example of the model, there is a neural network.

The detection unit 130 may include a processing unit that generates a parameter to be input to the artificial intelligence model, in addition to the statistical processing unit 131 and the form information generation unit 132.

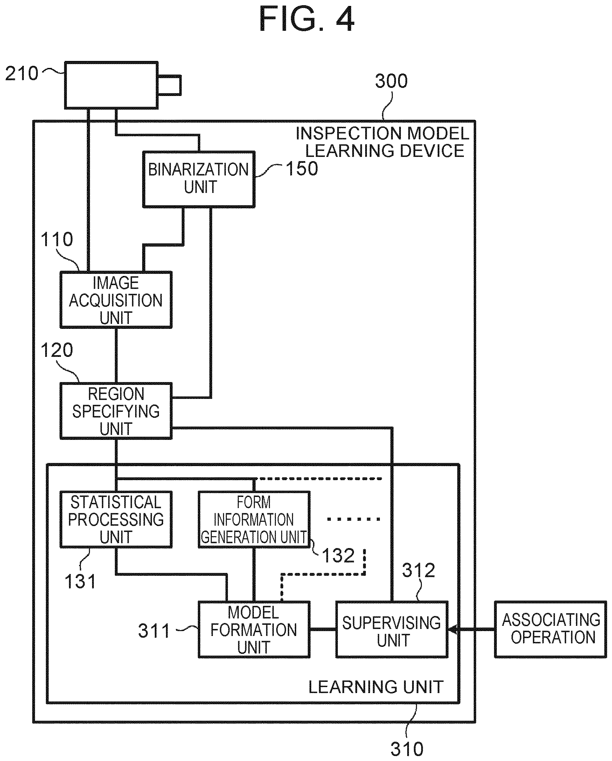

For example, a model that has performed learning using an inspection model learning device 300 shown in FIG. 4 is employed as the artificial intelligence model that is provided in the artificial intelligence unit 133. The inspection model learning device 300 will be described later.

The display device 160 is a device that gives information regarding a detection result of the detection unit 130. The display device 160 may give only information as to whether the flaw exists. Further, in the case where the flaw is detected, the display device 160 may give information regarding the number of flaws, the magnitude (length) of the flaw, and the like. Furthermore, together with the image acquired by the image acquisition unit 110, the display device 160 may display the position of the flaw using a different color or the like.

The inspection model learning device 300 shown in FIG. 4 includes an image acquisition unit 110, a region specifying unit 120, a binarization unit 150 and a learning unit 310. The inspection model learning device 300 includes constituents that are the same as those of the magnetic particle inspection device 100, and processing units having the same functions are denoted by the same reference numerals, and descriptions of the processing units are sometimes omitted.

The learning unit 310 includes a statistical processing unit 131, a form information generation unit 132, a supervising unit 312 and a model formation unit 311. In the learning unit 310, a processing unit that generates a parameter to be input to the model formation unit 311 may be provided in addition to the statistical processing unit 131 and the form information generation unit 132. A broken line and a dotted line in FIG. 4 suggest the possibility that such a processing unit may be provided.

The supervising unit 312 is a processing unit that inputs flaw information indicating whether the magnetic particle group 202 specified by the region specifying unit 120 is attached to a flaw, to the model formation unit 311, in association with the magnetic particle group 202. Parameters regarding the magnetic particle group 202 are calculated by the statistical processing unit 131 and the form information generation unit 132.

Specifically, for example, the image-capturing device 210 captures the images of inspection objects 200 in each of which the existence of the flaw has been confirmed. Based on the obtained images, an operator associates each of a plurality of magnetic particle groups 202 specified by the region specifying unit 120, with information regarding whether the magnetic particle group 202 is attached to a flaw. The supervising unit 312 acquires the flaw information associated with each magnetic particle group 202 by the operator, and inputs information regarding whether each magnetic particle group 202 is attached to a flaw.

The model formation unit 311 includes the same kind of artificial intelligence model as that of the magnetic particle inspection device 100, and inputs the magnetic particle group 202, parameters acquired from the same kind of statistical processing unit 131 as that in the magnetic particle inspection device 100, the same kind of form information generation unit 132 as that in the magnetic particle inspection device 100, and the like, and the flaw information to the artificial intelligence model, and thus forms an artificial intelligence model that can determine with high probability whether the magnetic particle group 202 is attached to a flaw.

The inspection model learning device 300 performs the supervised learning based on a predetermined number of inspection objects 200, and provides the formed artificial intelligence model to the artificial intelligence unit 133 of the magnetic particle inspection device 100.

As described above, the magnetic particle inspection device 100 according to the embodiment performs the inspection, by extracting, from the image, the magnetic particle group 202 that is a portion where the flaw may exist, and eliminating edges and the like based on the parameters obtained from the magnetic particle group 202 and the magnetic particle group region 203 that contains the magnetic particle group 202, instead of detecting a flaw by performing learning such as deep learning on the whole of the image. Accordingly, it is possible to reduce a flaw undetection rate, and to reduce a flaw false-detection rate.

For example, by including the average of the luminances, the standard deviation of the luminances, the normalized inertia moment and the elongation factor as the parameter, it is possible to reduce the flaw undetection rate to a value equal to or lower than 5%, and to reduce the flaw false-detection rate to a value equal to or lower than 10%. Furthermore, the increase in the learning amount for the artificial intelligence model, the addition of the kinds of the parameters, and so on can lead to a flaw undetection rate of 0% and a flaw false-detection rate of 5% or lower.

The invention is not limited to the above embodiment. For example, the invention may be carried out as other embodiments that are realized by combining any two or more of the constituent elements described in the specification and eliminating some of the constituent elements. Further, the invention includes also modified examples that are obtained by making various modifications conceived by a person skilled in the art to the above embodiment, within a range of the scope of the invention, that is, without departing from meanings of words described in the claims.

For example, in the above embodiment, the fluorescent magnetic particle is used as the magnetic particle 201. However, a non-fluorescent magnetic particle having a predetermined color may be used. The predetermined color is a color different from the color of the surface of the inspection object 200, and, for example, red, black, white or the like can be used depending on the color of the inspection object. In the case of using the non-fluorescent magnetic particle, the magnetic particle inspection device 100 may include a light device that radiates visible light, instead of the black light. In this case, the recognition of the magnetic particle 201 from the image may be performed based on the predetermined color. For example, in the case where the non-fluorescent magnetic particle is red, the non-fluorescent magnetic particle may be detected based on the luminance value of R in an RGB image. When the non-fluorescent magnetic particle is used in this way, in some cases, it is possible to photograph each magnetic particle 201 more clearly than when the luminescent fluorescent magnetic particle is used, and to enhance the accuracy of the information that is obtained from the magnetic particle group 202.

In the magnetic particle inspection device 100, the detection result is output on the display device 160, but the invention is not limited to this configuration. For example, a notification regarding the detection result may be given through a lamp, a speaker or the like. In this case, the magnetic particle inspection device 100 does not need to include the display device 160.

The inspection object 200 that is inspected by the magnetic particle inspection device 100 is not limited to the rack shaft. The inspection object 200 may be any member, for example, a component of a gear or a bearing, as long as the member is a ferromagnetic body that allows the magnetic particle inspection.

The invention can be used as a system and a device configured to perform the magnetic particle inspection.

## Claims

1. A magnetic particle inspection device **characterized by** comprising:
an image acquisition unit (110) configured to acquire an image that is obtained by attaching magnetic particles (201) to an inspection object (200) that is magnetized and capturing the image of the inspection object (200), and a binarized image that is obtained by binarizing a whole or a part of the image;
a region specifying unit (120) configured to specify a magnetic particle group region (203) based on at least one of the image and the binarized image, the magnetic particle group region (203) containing a magnetic particle group (202) that is a mass of the magnetic particles (201); and
a detection unit (130) configured to detect a flaw by processing luminance information and form information with artificial intelligence that is obtained by supervised learning, the luminance information being obtained by performing statistical processing on luminances of a plurality of minute regions in the specified magnetic particle group region (203), and the form information being information regarding a form of the magnetic particle group (202) that is obtained from the binarized image.

2. The magnetic particle inspection device according to claim 1, **characterized in that** the luminance information is at least one of an average of the luminances and a standard deviation of the luminances.

3. The magnetic particle inspection device according to claim 1 or 2, **characterized in that** the form information is at least one of a normalized inertia moment and an elongation factor.
